# DEMANDE DE BREVET EUROPEEN

(11) **EP 1 079 439 A1**
(43) Date de publication de la demande: **28.02.2001**
(21) Numéro de dépôt: 00402190.3
(22) Date de dépôt: 31.07.2000
(51) Int. Cl.: H01L 31/0203, H01L 21/60

(54) **Procédé de mise en boîtier d'une puce à capteurs et dispositif semi-conducteur ou boîtier**

(30) Priorité: 27.08.1999 FR 9910841
(71) Demandeur: STMicroelectronics SA, 94250 Gentilly Cedex (FR)
(72) Inventeur: Brechignac, Rémi, 38000 Grenoble (FR); Exposito, Juan, 38330 Saint Nazaire les Eymes (FR)
(74) Mandataire: Casalonga, Axel

(57) **Abrégé**

Procédé de mise en boitier d'une puce à circuits intégrés et dispositif semi-conducteur ou boîtier à circuits intégrés, dont une face avant (2) présente des capteurs en particulier optiques dans sa partie centrale et des zones de connexion électrique dans une partie située entre au moins l'un de ses bords et ladite partie centrale. Une face arrière de ladite puce (1) est collée sur une face avant (17) d'un substrat ou film (8) comprenant des passages traversants (9) et des zones de connexion électrique (14) sur sa face arrière (13) passant devant ces passages traversants, dans une position telle que lesdits passages traversants soient situés latéralement audit bord de ladite puce (1). Les zones de connexion de la face avant de ladite puce sont reliées auxdites zones de connexion du substrat, au travers desdits passages traversants, au moyen de fils de connexion (18). Ladite puce (1) et lesdits fils de connexion (18) sont noyés dans un matériau d'encapsulage formant un bloc (23) du côté de la face avant (17) dudit substrat (8), ce matériau d'encapsulage étant optiquement transparent. Ledit substrat (8) est découpé autour dudit bloc d'encapsulage (23) en suivant le pourtour de ce bloc.

## Description

La présente invention concerne un procédé de mise en boîtier d'une puce à circuits intégrés qui présente des capteurs en particulier optiques et un dispositif semi-conducteur ou boîtier renfermant une telle puce.

Pour la mise en boîtier d'une puce à circuits intégrés présentant des capteurs sur sa face avant, il est connu de coller la face arrière de cette puce sur un substrat rigide en céramique, de relier électriquement, par des fils de connexion, des bornes de la puce à des zones de connexion de la face avant du substrat, ce dernier présentant des pistes de connexion électrique qui contournent ses bords de façon à relier électriquement ses zones de connexion avant à des zones de connexion arrière. Puis, dans une première variante, on colle un couvercle s'étendant en avant de la face avant de la puce ou, dans une autre variante, on noye la puce et les fils de connexion dans une résine d'encapsulage transparente.

Compte tenu des matériaux utilisés et des modes de connexion électrique choisis, de tels boîtiers présentent nécessairement un contour carré ou rectangulaire suivant le contour de la puce et son coût de fabrication est relativement élevé.

La présente invention a pour but de simplifier et de réduire le coût de la mise en boîtier d'une puce à capteurs en particulier optiques, tout en augmentant ses possibilités d'utilisation ultérieure.

La présente invention a tout d'abord pour objet un procédé de mise en boitier d'une puce à circuits intégrés dont une face avant présente des capteurs en particulier optiques dans sa partie centrale et des zones de connexion électrique dans une partie située entre au moins l'un de ses bords et ladite partie centrale.

Selon l'invention, ce procédé consiste à coller une face arrière de ladite puce sur une face avant d'un substrat comprenant des passages traversants et des zones de connexion électrique sur sa face arrière passant devant ces passages traversants, dans une position telle que lesdits passages traversants soient situés latéralement audit bord de ladite puce ; à relier les zones de connexion de la face avant de ladite puce auxdites zones de connexion du substrat, au travers desdits passages traversants, au moyen de fils de connexion ; à noyer ladite puce et lesdits fils de connexion dans un matériau d'encapsulage formant un bloc du côté de la face avant dudit substrat, ce matériau d'encapsulage étant optiquement transparent ; et à découper ledit substrat autour dudit bloc d'encapsulage en suivant le pourtour de ce bloc.

Le procédé selon l'invention peut avantageusement consister à former un bloc dont le pourtour est circulaire et à découper ledit substrat en suivant le pourtour circulaire de ce bloc.

Le procédé selon l'invention peut avantageusement consister à découper ledit substrat par poinçonnage.

La présente invention a également pour objet un dispositif semi-conducteur ou boitier à capteurs en particulier optiques qui comprend comprend une puce à circuits intégrés dont une face avant présente des capteurs optiques dans sa partie centrale et des zones de connexion électrique entre au moins l'un de ses bords et cette partie centrale ; un substrat sur une face avant duquel est fixée une face arrière de ladite puce et présentant sur sa face arrière des zones de connexion électrique passant devant des passages traversants situés latéralement audit bord de la puce ; des fils de connexion électrique reliant lesdites zones de connexion de la face avant de ladite, puce et les zones de connexion électrique du substrat, au travers desdits passages ; et un matériau d'encapsulage formant un bloc dans lequel ladite puce et lesdits fils de connexion sont noyés, accolé à la face avant dudit substrat, ledit matériau d'encapsulage étant optiquement transparent et le pourtour dudit substrat suivant le pourtour dudit bloc d'encapsulage.

Selon l'invention, le pourtour dudit bloc peut avantageusement être circulaire, le pourtour découpé du substrat étant alors aussi circulaire.

Selon l'invention, ledit substrat est de préférence constitué par un film, en particulier en résine époxy, présentant des zones de connexion sérigraphiées ou laminées.

Selon une variante de l'invention, la face avant dudit bloc d'encapsulage est plate.

Selon une autre variante de l'invention, la face avant dudit bloc d'encapsulage présente une partie bombée constituant une lentille optique.

Selon l'invention, le flanc dudit bloc d'encapsulage peut avantageusement être au moins en partie tronconique, facilitant ainsi la découpe du substrat.

Selon l'invention, le pourtour dudit bloc d'encapsulage passe de préférence au voisinage des coins de ladite puce.

La présente invention sera mieux comprise à l'étude des différentes étapes d'une mise en boîtier d'une puce à capteurs optiques et d'un boîtier ainsi obtenu, décrits à titre d'exemples non limitatifs et illustrés par le dessin sur lequel :
- la figure 1 représente une vue de dessus d'un dispositif semi-conducteur après une première étape de fabrication ;
- la figure 2 représente une coupe transversale du dispositif semi-conducteur de la figure 1 ;
- la figure 3 représente une coupe transversale du dispositif semi-conducteur après une deuxième étape de fabrication ;
- la figure 4 représente une coupe transversale du dispositif semi-conducteur après une troisième étape de fabrication dans sa forme définitive ;
- et la figure 5 représente une vue de dessus du dispositif semi-conducteur de la figure 1.

En se reportant aux figures, on voit qu'on a représenté une puce 1 à circuits intégrés en forme de parallélipipède dont le contour est carré et qui présente sur sa face avant 2 une partie centrale 3 renfermant une multiplicité de capteurs optiques dont le contour est carré et suit le contour de la puce 1.

Sur sa face avant 2, la puce 1 comprend également, dans ses deux parties situées entre deux de ses bords opposés 4 et 5 et les bords correspondants de la partie centrale 3, deux séries de zones frontales de connexion électrique 6 et 7 réalisées en surface.

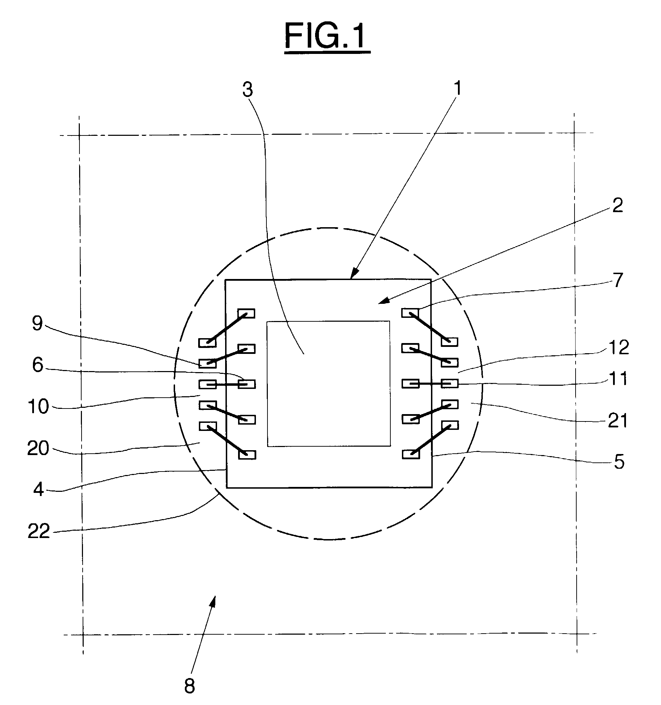

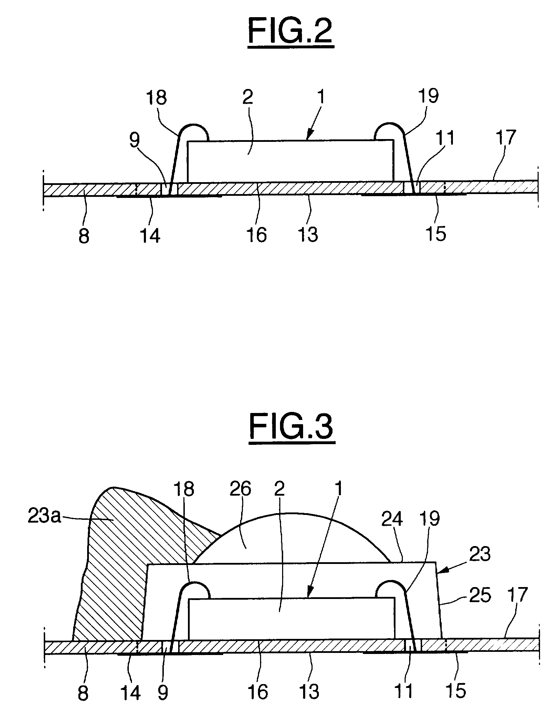

En se reportant aux figures 1 et 2, on voit qu'on a représenté un film fin 8 en une matière plastique telle que l'epoxy, qui présente une multiplicité de passages traversants 9 réalisés dans une plage 6 et une multiplicité de passages traversants 11 réalisés dans une plage 12, les plages 10 et 12 étant séparées d'une distance au moins égale à la distance séparant les bords opposés 4 et 5 de la puce 1.

Sur sa face arrière 13, le film 8 est muni d'une multiplicité de zones métalliques de connexion électrique 14 qui passent respectivement devant les passages traversants 9 et d'une multiplicité de zones métalliques de connexion 15 qui passent respectivement devant les passages traversants 11, ces zones métalliques 14 et 15 étant réalisées antérieurement par exemple par sérigraphie.

Afin d'encapsuler la puce 1 de façon à obtenir un boîtier, on peut procéder de la manière suivante.

On procède à la fixation par collage de la face arrière 16 de la puce 1 sur la face avant 17 du film 8, dans une position telle qu'elle s'étend entre les plages de connexion 10 et 12 et que ses bords 4 et 5 soient respectivement situés du côté de ces plages 10 et 12.

Ensuite, on relie les zones de connexion électrique 6 de la puce 1 aux zones de connexion électrique arrière 14 du film 8, au travers des passages traversants 9, au moyen de fils de connexion électrique 18 en l'air et on relie les zones frontales de connexion électrique 7 de la puce 1 aux zones de connexion électrique arrière 15 du film 8, au travers des passages traversants 11, au moyen des fils de connexion électrique 19 en l'air.

Comme on le voit bien sur la figure 1, les passages traversants 9 et les passages traversants 11 sont formés au plus près des bords 4 et 5 de la puce 1 fixée sur le film 8, à une distance compatible avec les caractéristiques de fonctionnement d'une machine automatique de pose des fils de connexion 18 et 19.

De plus, les orifices traversants 9 et 11 sont formés dans des espaces 20 et 21 s'étendant entre les bords 4 et 5 de la puce 1 et un cercle virtuel 22 passant par les coins de la puce 1 ou dans le voisinage de ces coins.

Dans une étape suivante, comme le montre la figure 3, on moule, dans un moule 23a représenté partiellement, un bloc d'encapsulage 23 en une matière plastique optiquement transparente, au-dessus de la face avant 17 du film 8, dans lequel on noye la puce 1 et les fils de connexion électrique 18 et 19, la matière constituant le bloc 23 étant par exemple une résine époxy.

Comme le montrent les figures 3 à 5, le bloc 23 présente une face avant 24 parallèle à la face avant 2 de la puce 1 et présente un pourtour 25 circulaire, droit ou légèrement en dépouille, ce pourtour 25 passant au voisinage des coins de la puce 1, de préférence au plus près possible.

Dans une variante, la face avant 24 du bloc 23 peut avantageusement présenter, dans sa partie centrale, une partie en saillie bombée 26 constituant une lentille optique orientée vers la partie centrale à capteurs 3.

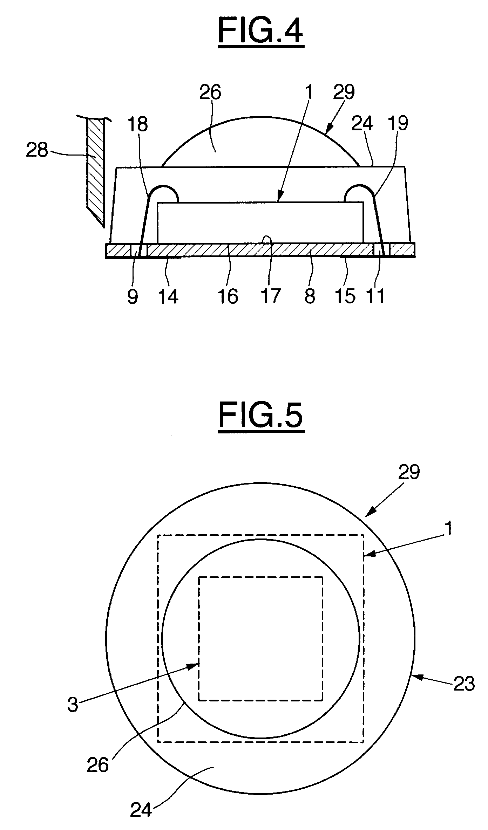

Dans une étape suivante, comme le montre le figure 4, on procède au découpage du film 8 en suivant le pourtour 25 du bloc 23, au plus près possible de ce pourtour, par exemple par poinçonnage grâce à un poinçoin 28 représenté schématiquement.

On obtient alors un boîtier étanche 29, à encombrement réduit, et à pourtour circulaire.

Ce boîtier peut aisément être installé dans un support tubulaire. Les zones de connexion électrique 14 et 15 de la face arrière 13 du boîtier 29 peuvent être connectées électriquement par tout moyen connu, par exemple par soudure de fils de connexion électrique ou par dépôt de gouttes d'un matériau de soudure d'accouplement.

Bien entendu, les opérations qui viennent d'être décrites peuvent être réalisées en différents endroits d'un film unique 8 afin de réaliser en même temps plusieurs boîtiers 29 sur un même film, l'opération de moulage étant commune et chaque boîtier étant ensuite séparé par poinçonnage comme décrit précédemment par exemple en une seule opération.

La présente invention ne se limite pas à l'exemple ci-dessus décrit. Bien des variantes de réalisation sont possibles sans sortir du cadre défini par les revendications annexées.

## Revendications

1. Procédé de mise en boitier d'une puce à circuits intégrés dont une face avant présente des capteurs en particulier optiques dans sa partie centrale et des zones de connexion électrique (6) dans une partie (10) située entre au moins l'un de ses bords (4) et ladite partie centrale (3), caractérisé par le fait qu'il consiste :
- à coller une face arrière (16) de ladite puce (1) sur une face avant (17) d'un substrat (8) comprenant des passages traversants (9) et des zones de connexion électrique (14) sur sa face arrière (13) passant devant ces passages traversants, dans une position telle que lesdits passages traversants (9) soient situés latéralement audit bord (4) de ladite puce (1) ;
- à relier les zones de connexion (6) de la face avant de ladite puce auxdites zones de connexion (14) du substrat, au travers desdits passages traversants (9), au moyen de fils de connexion (18) ;
- à noyer ladite puce (1) et lesdits fils de connexion (18) dans un matériau d'encapsulage formant un bloc (23) du côté de la face avant dudit substrat, ce matériau d'encapsulage étant optiquement transparent ;
- et à découper ledit substrat (8) autour dudit bloc d'encapsulage en suivant le pourtour (25) de ce bloc.

2. Procédé selon la revendication 1, caractérisé par le fait qu'il consiste à former un bloc (23) dont le pourtour est circulaire et à découper ledit substrat (8) en suivant le pourtour circulaire de ce bloc.

3. Procédé selon l'une des revendications 1 et 2, caractérisé par le fait qu'il consiste à découper ledit substrat (8) par poinçonnage.

4. Dispositif semi-conducteur ou boitier à capteurs optiques, caractérisé par le fait qu'il comprend :
- une puce (1) à circuits intégrés dont une face avant (2) présente des capteurs en particulier optiques dans sa partie centrale (3) et des zones de connexion électrique (6) entre au moins l'un de ses bords et cette partie centrale ;
- un substrat (8) sur une face avant (17) duquel est fixée une face arrière (16) de ladite puce (1) et présentant sur sa face arrière (13) des zones de connexion électrique (14) passant devant des passages traversants (9) situés latéralement audit bord de la puce ;
- des fils de connexion électrique (18) reliant lesdites zones de connexion de la face avant (6) de ladite puce et les zones de connexion électrique (14) du substrat, au travers desdits passages ;
- et un matériau d'encapsulage formant un bloc (23) dans lequel ladite puce et lesdits fils de connexion sont noyés, accolé à la face avant dudit substrat, ledit matériau d'encapsulage étant optiquement transparent et le pourtour dudit substrat suivant le pourtour (25) dudit bloc (23) d'encapsulage.

5. Dispositif selon la revendication 4, caractérisé par le fait que le pourtour (25) dudit bloc est circulaire.

6. Dispositif selon l'une des revendications 4 et 5, caractérisé par le fait que ledit substrat (8) est constitué par un film, en particulier en résine époxy, présentant des zones de connexion (14) sérigraphiées ou laminées.

7. Dispositif selon l'une quelconque des revendications 4 à 6, caractérisé par le fait que la face avant (24) dudit bloc d'encapsulage (23) est plate.

8. Dispositif selon l'une quelconque des revendications 4 à 6, caractérisé par le fait que la face avant (24) dudit bloc d'encapsulage (23) présente une partie bombée (26) constituant une lentille optique.

9. Dispositif l'une quelconque des revendications 4 à 8, caractérisé par le fait que le flanc (25) dudit bloc d'encapsulage (23) est au moins en partie tronconique.

10. Dispositif l'une quelconque des revendications 4 à 9, caractérisé par le fait que le pourtour (25) dudit bloc d'encapsulage (23) passe au voisinage des coins de ladite puce (1).
